Europäisches Patentamt

European Patent Office

Office européen des brevets

(19)

(11) Numéro de publication: **0 213 975**
**B1**

(12) **FASCICULE DE BREVET EUROPEEN**

(45) Date de publication du fascicule du brevet: 25.04.90

(51) Int. Cl.⁵: **G 05 B 19/42**

(21) Numéro de dépôt: 86401374.3

(22) Date de dépôt: 23.06.86

(54) Procédé et dispositif automatiques de correction de programmes d'usinage pour machines à commande numérique, en référence avec un plan de référence métrologique.

(30) Priorité: 25.06.85 FR 8509666

(43) Date de publication de la demande:
11.03.87 Bulletin 87/11

(45) Mention de la délivrance du brevet:
25.04.90 Bulletin 90/17

(84) Etats contractants désignés:
AT BE CH DE GB IT LI LU NL SE

(56) Documents cités:
EP-A-0 134 045
FR-A-2 549 676

(73) Titulaire: UP SYSTEMS
42-44 Rue des Meuniers
F-93100 Montreuil (FR)

(72) Inventeur: Primat, Didier
15 chemin du Bois Caran Collonge Bellerive
CH-1245 Geneve (CH)
Inventeur: Beauvois, Jacques
3 place des Vosges
F-75004 Paris (FR)
Inventeur: Basset, Frédéric
33 rue Frémicourt
F-75015 Paris (FR)
Inventeur: Bouin, Thierry
Résidence Le Nerprun
F-28500 Boutigny (FR)
Inventeur: Billiotte, Jean-Marie
8 place des Fédérés
F-93160 Noisy Le Grand (FR)

(74) Mandataire: Tony-Durand, Serge
Cabinet Tony-Durand 77, rue Boissière
F-75116 Paris (FR)

Courier Press, Leamington Spa, England.

EP 0 213 975 B1

## Description

La présente invention concerne un procédé et un dispositif pour corriger automatiquement les programmes d'usinage de machines à commande numérique. Elle concerne particulièrement la correction de programme d'usinage du type réalisé par mesure de coordonnées à partir d'un plan de référence métrologique.

Les principes de programmation de ce type sont rencontrés traditionnellement pour assurer la commande de machines à commande numérique d'usinage à plat et notamment de perceuses à commande numérique.

On connaît principalement deux méthodes pour générer les outillages de production de circuits imprimés au sein d'un bureau d'études. Une première méthode manuelle, est mise en oeuvre le plus souvent dans le cas de la réalisation de prototypes lorsque l'on ne dispose que d'un plan de référence. Les machines de programmation classiques intéressées pour mettre en oeuvre cette première méthode, opèrent optiquement à partir d'un plan de référence et sont généralement entièrement manuelles. Elle sont constituées par la combinaison entre:

un dispositif optique d'axe (Z Z') et notamment un rétroprojecteur complété par un écran,

un système mécanique de déplacement bidirectionnel, assurant le mouvement selon deux axes (X X') et (Y Y') d'une platine perpendiculairement à l'axe optique (Z Z') du dispositif optique,

un système de commande de déplacement manuel du système mécanique vis-à-vis d'un banc fixe et notamment deux molettes ou un levier manipulateur permettant la commande de déplacement manuel,

des moyens de détermination des coordonnées du point de la platine située à le verticale du dispositif optique, vis-à-vis d'un repère lié au dispositif optique, et notamment deux règles optiques,

un calculateur assurant la mise en forme des séquences de programme conformément au code utilisé par les machines à commande numérique concernées,

et enfin un système d'écriture, sur un support primaire de la séquence du programme d'usinage devant être lue par la machine à commande numérique.

Le plan de référence métrologique est fixé sur la platine.

Le procédé général de programmation manuelle consiste, pour l'opérateur:

à commander le déplacement manuel de la platine pour visualiser successivement sur l'écran les figures d'usinage à programmer,

à se centrer successivement, à l'aide du dispositif optique, sur certains points centraux desdites figures d'usinage,

et à enregistrer les coordonnées de ces points centraux.

Le calculateur assure le mise en forme de ces coordonnées numériques et met en forme une séquence de programme destinée en theorie à permettre l'usinage fidèle des figures par la machine à commande numérique. Cette séquence est stockée sur un support de programme telle une bande perforée à l'aide d'un dispositif d'écriture adapté.

Cette formule de programmation manuelle présente divers défauts.

Elle nécessite tout d'abord, lorsque le programme est réalisé manuellement, une grande acuité visuelle.

Elle aboutit à une précision assez faible.

Une seconde méthode de plus en plus utilisée consiste à générer l'outillage de production et notamment le plan de référence grâce à un système de conception assisté par ordinateur (CAO). Cette méthode sera décrite plus loin.

Dans tous les cas, il arrive fréquemment que le plan de référence métrologique ait plusieurs fonctions et qu'il intervienne à divers stades de l'usinage des produits concernés. L'utilisation de la séquence de programmation peut s'avérer nécessaire bien après la programmation préalable, à un autre endroit et dans des conditions fort différentes. Cette différence entre les conditions de programmation et d'utilisation des programmes, aboutit trés souvent à des déformations du plan de référence métrologique, dues à des contraintes mécaniques (pliage) ou à des contraintes thermiques, non réversibles.

En sorte que si le procédé de fabrication nécessite l'utilisation combinée:

à la fois de la séquence de programmation, préalablement réalisée, pour effectuer un usinage,

et sensiblement au même moment du plan de référence pour constituer une référence métrologique relative à un autre usinage,

il n'y aura pas concordance entre les deux types d'usinage.

Ce problème est particulièrement sensible lorsque l'on fabrique des produit de haute précision tels que des composants électroniques qui nécessitent à la fois des usinages dont la programmation est exercée à partir d'un cliché de référence et des opérations de sérigraphie réalisées avec le même cliché.

Pour résoudre ce probléme, on est fréquemment contraint de ne tirer aucun parti d'une programmation préalablement effectuée et de recommencer, sur le lieu d'utilisation, une nouvelle programmation correspondant à l'état géométrique du plan au moment de l'usinage.

Cette nouvelle programmation est généralement effectuée manuellement, selon le procédé décrit plus haut.

On aboutit au même résultat lorsque des programmes d'usinage et un plan de référence métrologique sont édités automatiquement par un système de conception automatique assisté par ordinateur (CAO).

Il arrive en effet fréquemment, soit que le traceur génère des erreurs métrologiques, soit que le support physique du plan se déforme avant usinage des pièces. En sorte qu'au moment de l'utilisation, il n'y a plus concordance entre la séquence programme d'usinage et le plan de référence métrologique.

Le procédé et le dispositif de l'invention permettent de remédier é cet inconvénient.

A cet effet, le procédé de l'invention consiste de maniére usuelle:

à réaliser, à partir du plan de référence, ou selon toute méthode connue, une séquence initiale de programme pour machines à commande numérique,

et à mémoriser la séquence initiale de programme sur un support de programme primaire. Cette séquence initiale peut donc:

soit être éditée par un systéme de CAO.

soit programmée manuellement selon le principe décrit plus haut.

L'invention concerne le traitement de plans de référence métrologique dont les figures du tracé d'usinage sont discernables du fond par un paramètre spécifique tel que le niveau de gris.

Le procédé de l'invention est remarquable par le fait que, contrairement au principe classique, et précédemment à l'introduction de la séquence initiale de programme à l'intérieur de la machine à commande numérique:

on lit, notamment sur un système indépendant de contrôle et de correction, le support de programme primaire et on déchiffre la séquence de programme initiale,

on isole à partir de cette séquence de programme initiale, une série de figures théoriques devant être usinée par la machine à commande numérique,

et on détermine successivement les coordonnées théoriques d'un point central de chaque figure théorique.

On exploite donc, au titre de contrôle, les informations contenues à l'intérieur de la séquence de programme initiale.

Puis,

on déplace, au cours d'unc seconde phase de contrôle, le plan de référence face à un systéme optique, de manière à amener successivement à la verticale de l'axe du système, le point central de chaque figure théorique,

on saisit successivement une image de contrôle entourant chaque point central théorique et la figure correspondante,

on digitalise successivement ladite image de contrôle en une image binaire de contrôle sur laquelle ladite figure apparaît avec un niveau binaire spécifique,

on effectue successivement un traitement électronique automatique de chaque image binaire de contrôle et on détermine les coordonées exactes, relativement au plan de référence, des figures à usiner,

on génère une nouvelle séquence de programme corrigée, sur la base des coordonnées exactes déterminées,

enfin, on mémorise la nouvelle séquence programme corrigée sur un support de programme secondaire.

On peut alors utiliser la nouvelle séquence programme corrigée pour usiner les pièces, sur une machine à commande numérique, en étant certain de la conformité de l'usinage avec le plan de référence.

L'invention se distingue, en particulier, par le fait qu'on utilise les données de position des figures contenues dans la séquence de programme initiale pour commander automatiquement la séquence de déplacement nécessaire à la phase de correction de programmation.

Préférentiellement, on conserve la structure de la séquence programme initiale pour la séquence de programme corrigée. On remplace simplement les valeurs numériques fausses relatives aux figures sensible théoriques, par des valeurs numériques exactes correspondant avec précision à la géométrie et à la position des figures telles que déterminées selon le procédé de la revendication.

Les avantages offerts par l'invention sont:

une conformité complète au moment de l'usinage entre le plan de référence métrologique et les données géométriques d'usinage de la séquence primaire de programme,

une précision d'usinage absolue.

une automatisation complète du contrôle et de la correction des programmes,

et la non nécessité d'effectuer une programmation initiale très précise, du fait que celle-ci est ultérieurement corrigée.

les principales caractéristiques, variantes et avantages de l'invention, se dégagent de la description qui va suivre en regard des dessins, annexés, lesquels descriptions et dessins ne sont donnés qu'a titre d'exemples non limitatifs d'utilisation du procédé de l'invention dans le domaine spécifique de la correction de programmes de perçage de circuits imprimés pour perceuses à commande numérique, réalisés par métrologie à partir de clichés.

Sur ces dessins:

In figure 1 est un schéma représentant les étapes classiques de correction manuelle visuelle d'un programme de perçage de circuits imprimés à partir d'un cliché de référence;

In figure 2 est un schéma, représentant les étapes complémentaires, recommandées par l'invention, pour assurer une correction automatique d'une séquence programme de perçage primaire avant utilisation et les mettre en conformité avec le cliché de référence;

In figure 3 est une vue en perspective, schématique, d'un dispositif selon l'invention, destiné à assurer la correction automatique de programmes de perçage.

Selon le procédé manuel classique, la programmation initiale de perçage de circuits imprimés s'effectue au bureau d'études à partir d'un cliché de référence (1). Le cliché (1) est constitué à partir d'un support (3) en matériau plastique transparent. Sur le support (3) sont matérialisés, par des zones opaques noires, à la fois des filaments de connecteurs (5, 6, 7, 8, 9, 10, 11) et des pastilles (15, 16, 17, 18).

Le cliché (1) a pû être réalisé:

soit à la suite d'une préparation d'outillage pratiquée par un bureau d'études sur un système de conception assisté par ordinateur (CAO) et édité sur un phototraceur,

soit manuellement par dessin ou report de figures autocollantes sur le support (3).

Il arrive également que le système (CAO) édite à la fois le cliché (1) et la bande de perçage (21) qui théoriquement devrait lui correspondre pour assurer le perçage des circuits par une perceuse à commande numérique. Dans ce cas, la programmation manuelle initiale n'est pas nécessaire.

On peut donc en théorie, selon la méthode classique, disposer à la sortie du bureau d'études à la fois du cliché de référence (1) et éventuellement d'une bande primaire (21) de programmation de perçage sur machine à commande numérique.

Mais la fabrication des circuits imprimés s'effectue généralement loin de bureau d'études qui a conçu le cliché (1) et la bande, en sous-traitance à l'intérieur d'usines spécialisées.

L'outillage de fabrication constitué notamment par le cliché (1) est donc transmis, notamment par la poste, à l'usine de circuits imprimés. Il arrive parfois que le cliché (1) soit accompagné de sa bande primaire (21). Mais entre la conception du cliché et la fabrication des circuits, il s'écoule un temps assez long. En outre, le support (3) du cliché (1) est un matériau très sensible aux variations thermiques. Au surplus, les manipulations du cliché (1), et notamment les roulages occasionnent des déformations mécaniques internes irréversibles. En sorte qu'il est fréquent qu'au moment de son ultilisation par l'usine de circuits imprimés, le cliché ait subi des déformations dimensionnelles globales de plusieurs centièmes voire de près d'un dixième de millimètre vis-à-vis de la topologie initiale de programmation. Ces erreur dues à des déformations sont renforcées par des erreurs de restitution du phototraceur dues notamment à une dérive des organes d'asservissement des moteurs et à des jeux mécaniques. Or, le perçage des circuits imprimés doit à l'heure actuelle atteindre une précision de l'ordre d'un centrièmes de millimètre du fait de la finesse et de la densité des pastilles.

En sorte que si l'on réalise les panneaux de circuits imprimés à l'aide du cliché de référence (1) et si l'on utilise la bande initiale de perçage (21) pour percer les panneaux de circuits, on aboutit fréquemment à des perçages décentres occasionnant ultérieurement des soudures sèches des composants et rendant les circuits imprimés inutilisables.

C'est la raison pour laquelle, la majorité des fabricants de circuits imprimés très performants sont contraints, au moment de la fabrication, de procéder à une nouvelle programmation de perçage, manuelle, bien qu'ils possèdent fréquemment une bande perforée primaire (21) de la séquence initiale de programme (41).

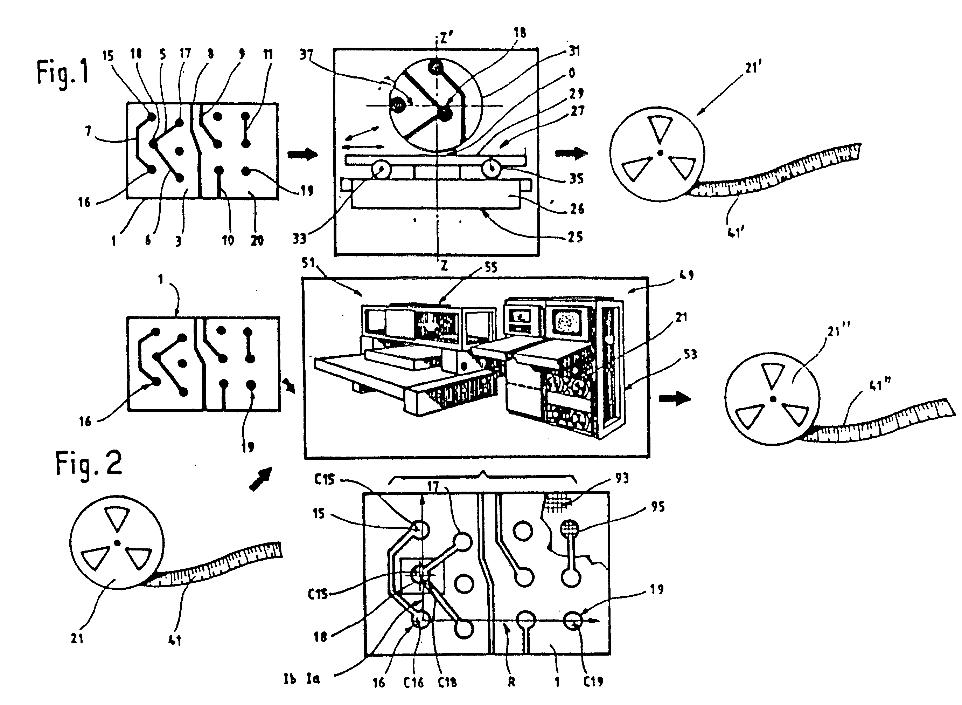

Selon le procédé manuel, cette programmation de correction, lorsqu'elle a lieu, s'effectue généralement manuellement. Elle est schématisée figure 1.

On utilise pour ce faire un coordinatographe classique (25) constitué par un banc (26) sur lesquel est fixé un système mécanique (27) déplaçant une platine (29) horizontalement dans deux directions (X X') et (Y Y'). Selon un axe fixe (Z Z') perpendiculaire au plan de la platine (29) est fixé un système optique (non représenté), tel un rétroprojecteur permettant de matérialiser sur un écran de visualisation (31), une zone située à l'intersection (0) de l'axe optique (Z Z') avec la platine (29). Le coordinatographe possède en outre des moyens de commande de déplacement manuel, constitués notamment par des molettes (33, 35) dont la rotation manuelle commande le deplacement de la platine (29) dans les directions (X X') et (Y Y').

Le cliché (1) est posé sur la platine (29). L'opérateur commande successivement le déplacement de la platine de manière à amener le centre de chaque pastille (18) en coincidence avec une mire fixe (37) de l'écran de visualisation (31). Les coordonnées de la position du point de la platine en coincidence avec l'axe (Z Z') vis-à-vis du banc (26) sont déterminées pour chaque centre. Le coordinatographe organise les coordonnées successives relatives à chaque centre de pastille sous la forme d'une séquence secondaire corrigée (41') en conformité avec le code de la perceuse à commande numérique devant être utilisé. Puis il génère sur un perforateur une bande perforée (21') corrigée, mémorisant la séquence secondaire (41').

Les informations données par cette bande secondaire corrigée (21') sont théoriquement en conformité avec le cliché (1), à l'intérieur de l'usine si l'opérateur n'a pas réalisé d'erreurs. On constatera qu'au cours de cette correction classique, l'opérateur n'utilise nullement une bande perforée primaire (21) qui aurait pû être délivrée par un (CAO) à l'issue de la conception du circuit. Il utilise le cliché (1) comme seule référence. C'est manuellement et sans référence à aucune séquence de programmation préalable (41) qu'il amène chaque pastille (16) à la verticale du dispositif optique.

En sorte que selon le procédé classique, la correction d'un cliché à l'aide d'un coordinatographe, pour aboutir, à une bande programme secondaire (21') corrigée est tout à fait identique à une phase de programmation initiale effectuée manuellement.

Au contraire, le procédé de correction automatique de programme de perçage selon l'invention est décrit figure 2. Il utilise comme élément de départ à la fois:

le cliché (1).

et une bande perforée primaire (21) mémorisant une séquence initiale de programme de perçage (41) préalablement réalisée.

Le séquence initiale de programme (41) a été réalisée soit par un coordinatographe selon le procédé décrit ci-dessus, soit a été générée par un système de (CAO) parallèlement à l'édition du cliché (1).

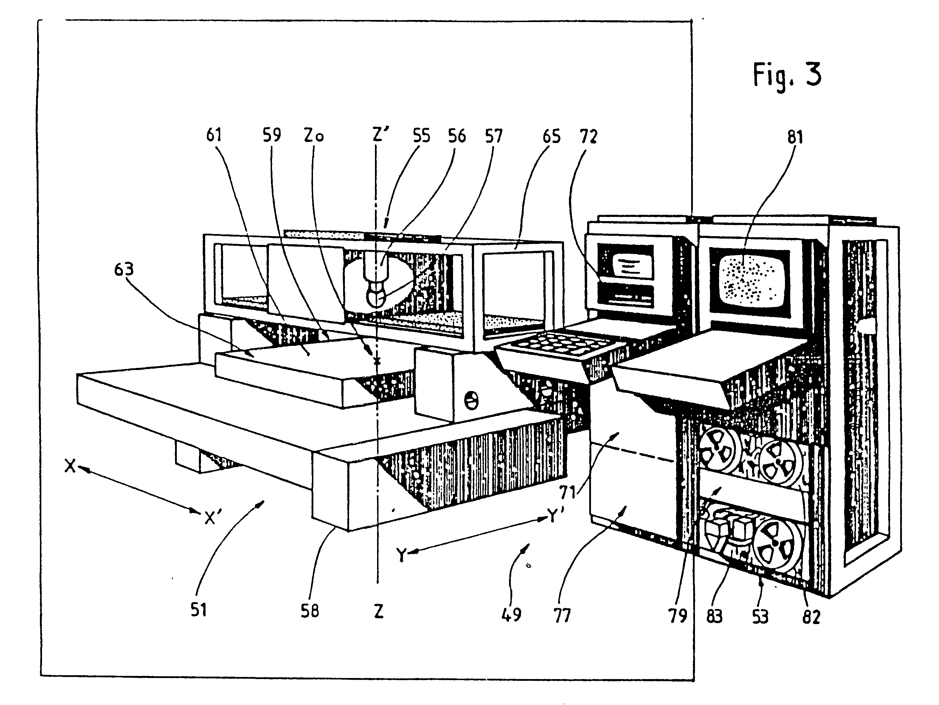

Dans son principe général, l'invention consiste à utiliser à l'intérieur de l'usine, un dispositif (49) de correction automatique de programme de perçage tel que représenté figure 3.

Celui-ci comporte une partie mécanique et optique (51) et un ensemble électronique de commande (53).

La partie mécanique et optique est constituée essentiellement par:

un dispositif optique (55) comportant une caméra (56) munie d'un objectif (57) d'axe optique (Z Z').

un banc fixe (58) en granit.

et un système mécanique (59) assurant, vis-à-vis du banc fixe (58) et selon les axes (X X') et (Y Y'), le déplacement bidirectionnel d'une platine mobile (61) surmontant une table à lumière (63).

Le dispositif optique (55) est maintenu vis-à-vis du banc fixe (58), par l'intermédiaire d'un chassis métallique (65). La table à lumière (63) assure l'éclairage sous-jacent de la platine (61) dans la zone (Zo) inspectée par le dispositif optique (55).

L'ensemble électronique de commande comporte principalement:

un calculateur à microprocesseur relié au système mécanique (59), par l'intermédiaire d'organes de puissance pour assurer le séquencement automatique de mouvements de la platine (61) selon (X X') et (Y Y'),

une unité de mémoire périphérique et notamment une unité de disquettes (72) assurant le stockage des instructions de fonctionnement nécessaires au calculateur (71),

un clavier (73) et un écran de contrôle (75) assurant le dialogue avec l'opérateur,

une station d'imagerie électronique (77), reliée à la caméra (56) et assurant le traitement électronique automatique des images,

un organe de commande de puissance (79) assurant, sous le contrôle du calculateur (71), la commande des moteurs du système mécanique (59) pour amener le table lumineuse (63) et la platine (61) dans une position (X Y) prédéterminée vis-à-vis de la caméra (56),

un écran couleur (81) d'affichage graphique évolutif des programmes de perçage,

un système de lecture (82) de bandes perforées primaires (21), support de séquences initiales de programme de perçage (41),

et un système de perforation (83) de bandes perforées secondaires (21''), support de séquence corrigée de programme de perçage (41'').

Le principe général de fonctionnement du dispositif (49) consiste tout d'abord à fixer le cliché (1) sur la platine transparente (61) de la table à lumière (63).

Celui-ci est éclairé en transparence en sorte que les pastilles (15 , ... 17) et les filaments (5 , ... 11) se distinguent nettement en noir vis-à-vis du fond clair (20).

Par ailleurs, on place la bande perforée primaire (21) sur le système de lecture (82). Le calculateur (71) commande la lecture de la bande perforée (21) et la déchiffrage de la séquence de programme initiale (41) de perçage qu'elle comporte.

Le cliché (1) et la bande perforée primaire (21) ont été générés par un système (CAO) l'intérieur d'un bureau d'études. Alors que la correction de la bande (21) s'effectue à l'aide du dispositif (49) à l'intérieur d'une usine de production. Le cliché (1) a été expédié par la poste et a subi, au cours du transport, des déformations mécaniques irréversibles. En sorte que les informations de la bande primaire (21) ne sont plus en concordance avec la géométrie initiale du cliché (1). Du fait de cette déformation, le centre théorique (C18) des pastilles (18) tel qu'il est mémorisé dans la séquence programme intiale (41) diffère sensiblement de la position réelle (C'18) du centre (voir figure 2). Si l'on procédait directement à un usinage des circuits sur une perceuse à commande numérique, on aboutirait à un excentrement des perçages de trous très préjudiciale au fonctionnement des circuits.

C'est la raison pour laquelle, il est recommandé pour l'invention, de commander successivement et automatiquement à l'aide du calculateur (71), le déplacement des centres théoriques (C'18) sensiblement à la verticale de l'axe (X X') de la caméra (56).

Puis on saisit successivement à l'aide du dispositif optique (55) une image de commande (Ia) entourant chaque centre théorique (C'18) et la pastille (18) correspondante.

L'image analogique (Ia) est transmise au système d'imagerie électronique (77) qui en assure une digitalisation sous la forme d'une image binaire (Ib) constituée de pixels blancs (23) significatifs du fond (20) et de pixels noirs (95) recouvrant les pastilles et les filaments. Le système d'imagerie (77) analyse électroniquement les images binaires de commande (Ib) et détecte automatiquement à l'aide d'un algorithme du type de celui décrit dans la demande de brevet français n° 85 09235, le centre exact (C'18) de chaque pastille (18). Le calculateur (71) assure le calcul de l'écart (C18, C'18) entre le centre théorique (C18) et le centre réel (C'18) de cheque pastille (18) au cours de la phase de correction. Enfin le calculateur (71) assure la mise en forme des coordonnées réelles des centres (C'18) des pastilles (18) sous la forme d'une séquence de programme corrigée (41'') conforme au code de la machine de perçage utilisée. Puis il assure la génération, sur le perforateur de bande (83), de la bande secondaire (21'') mémorisant la séquence de programme corrigée (41'').

La bande corrigée (21'') permet le perçage sur une machine à commande numérique de circuits en concordance parfaite avec le cliché (1).

Selon une variante avantageuse de l'invention on se fixe au cours de la programmation préalable sur le cliché de référence (1):

un point origine primaire (C16) correspondant au centre d'une pastille (16),

un point secondaire confondu avec le point origine,

et un point tertiaire (C19) correspondant au centre de la pastille (19).

Lors de la phase initiale de programmation, on prend le point origine primaire (C10) comme origine géométrique de la séquence de programme primaire (41). On se fixe également pour définir l'horizontale géométrique de la séquence primaire, le point primaire et secondaire (C16) et la point tertiaire (C19).

Au cours de la phase de correction, on amène l'axe (Z Z') du système optique (55) successivement à la verticale des points primaire (C16) et tertiare (C19) de référence. On détermine automatiquement un repère de référence (R) du cliché (1) en corrélation avec les points de référence (C16) et (C19). On détermine les coordonnées des points centraux théoriques (C18) dans le repère de référence (R) et on les mémorise.

Grâce à ces coordonnées théoriques, le calculateur (71) commande l'amenée successivement de chaque point central théorique (18) à la verticale de l'axe optique (Z Z') de la caméra (56).

On procède à la correction automatique de la position des points centraux à l'intérieur de la séquence secondaire (41''), selon le procédé décrit ci-dessus.

On constate que les procédés et le dispositif décrits ci-dessus permettent une correction entièrement automatique des bandes programmées (21).

L'invention ayant maintenant été décrite, et son intérêt justifié sur un exemple détaillé, les demandeurs s'en réservent l'exclusivité pendant toute la durée du brevet, sans limitation autre que celle des termes des revendications ci-après.

**Revendications**

1. Procédé automatique de correction de programme d'usinage (41) pour machines à commande numérique, en relation avec un plan de référence métrologique (1) sur lequel les figures (15, 16, 17, 18) du tracé d'usinage sont discernables du fond par un paramètre spécifique tel leur niveau de gris;
le procédé consistant:
à réaliser tout d'abord, à partir du plan de référence (1), une séquence initiale (41) de programme de la machine à commande numérique, ceci notamment sur un système de programmation classique (25),
et à mémoriser sur un support de programme primaire (21) l'ensemble de ladite séquence initiale du programme (41),
ledit procédé étant caractérisé, en combinaison, en ce qu'avant d'introduire ladite séquence initiale de programme (41) à l'intérieur de la machine à commande numérique:
on lit le support programme primaire (21) et on déchiffre sa séquence programme initiale (41).
on isole, à partir de cette séquence initiale de programme (41), une série de figures théoriques (15, 16, 17, 18) devant être usinée par la machine à commande numérique,
on détermine successivement les coordonnées théoriques d'un point central théorique (C15, C16, C17, C18) de chaque figure théorique (15, 16, 17, 18),

on déplace le plan de référence (1) face à un système optique (55), de manière à amener successivement sensiblement à la verticale de l'axe (Z Z') du système optique (55), le point central théorique (C15, C16, C17, C18) de chaque figure théorique (15, 16, 17, 18),

on saisit successivement une image de commande (Ia) entourant chaque point central théorique (C18) et englobant la figure (18) correspondante,

on digitalise successivement ladite image de commande (Ia) en une image binaire de commande (Ib) sur laquelle ladite figure théorique (18) apparaît avec un niveau binaire spécifique,

on effectue un traitement électronique automatique de l'image binaire de commande (Ib) et on détermine automatiquement les coordonnées exactes, sur le plan de référence (1), des figures à usiner,

on génère une nouvelle séquence programme corrigée (41''), sur la base des coordonnées exactes précédemment déterminées,

on mémorise la nouvelle séquence programme corrigée (41'') sur un support de programme secondaire (21''),

on peut alors utiliser la nouvelle séquence programme corrigée (41'') pour usiner, sur une machine à commande numérique, des pièces en conformité avec le plan de référence (1).

2. Procédé automatique selon la revendication 1 précédente, de correction de programme d'usinage (41) pour machines à commande numérique, ce procédé étant caractérisé en ce que l'on conserve, dans la séquence programme corrigée (41''), la structure de la séquence programme initiale (41); en remplace simplement les valeurs numériques fausses relatives aux figures théoriques, par des valeurs numériques exactes correspondant avec précision à la géométrie et à la position des figures théoriques telles que déterminées selon le procédé de la revendication 1.

3. Procédé automatique, selon l'une des revendications 1 et 2 précédentes, de correction d'un programme d'usinage pour machines à commande numérique, selon lequel:
on se fixe sur le plan de référence (1) un point origine (C16) de la séquence programme initiale (41),
ainsi qu'une horizontale de référence,
Ledit procédé étant caractérisé en combinaison en ce que:
on se fixe un point origine primaire (C16) de la séquence programme initiale confondu avec un point central caractéristique d'une figure (16) du plan de référence (1).

on se fixe également, pour définir l'horizontale, deux points secondaire et tertiaire (C19) d'alignement d'axes, dont l'un (C16) est éventuellement constitué par le point origine, confondu avec deux points centraux caractéristiques complémentaires de deux figures (19) de plan de référence,

et au cours de la phase de correction de la séquence programme, on amène l'axe (Z Z') du système optique (55) successivement, sensiblement à la verticale des points primaire (C16), secondaire et tertiaire (C19) de référence,

on détermine automatiquement un repère de référence (R) du plan (1), mobile vis-à-vis du dispositif optique (55),

on définit les coordonnées théoriques desdits points centraux théoriques (45) des figures théoriques (15) dans le repère de référence (R) du plan (1),

grâce à ces coordonnées théoriques, on amène successivement chaque point central théorique (C15) à la quasi verticale de l'axe (Z Z') du dispositif optique (55) pour procéder au contôle de la séquence programme initiale (41) et à sa correction automatique sur la forme de la séquence programme corrigée (41'').

4. Procédé automatique, selon l'une des revendications 1 à 3 précédentes, de correction de programme de perçage de circuits imprimés pour perceuses à commande numérique, ledît programme étant réalise à partir d'un cliché de référence (1) constitué par un support plan transparent (3) sur lequel sont disposés:

des pastilles noires (15, 16, 17, 18) à symétrie centrale dont de centre (C15, C16, C17, C18) matérialise les positions de perçage,

et éventuellement des connecteurs (5, 6, 7, 8, 9, 10, 11).

Ledît procédé étant caractérisé en ce que, en combinaison:

l'on réalise à partir du cliché de référence (1), notamment à l'aide d'un coordinatographe classique (25), une séquence initiale de programme de perceuses à commande numérique,

on mémorise la séquence initiale (41) du programme sur un support de programme primaire (21),

on lit, sur un système indépendant (49), le support de programme primaire (41) et on déchiffre la séquence du programme initiale de perçage (21),

on isole les coordonnées des centres théoriques (C18) de perçage confondus théoriquement avec le centre des pastilles (18),

on place le cliché de référence (1) sur la platine (61) d'un système mobile vis-à-vis de l'axe (Z Z') d'un dispositif optique (55) et on déplace le cliché (1),

on amène successivement et automatiquement les centres théoriques (C18) de perçage à la verticale de l'axe (Z Z') du dispositif optique (55),

on saisit successivement à l'aide du dispositif optique (55), une image de contrôle (Ia) entourant chaque centre théorique (C18) et la pastille (18) correspondante,

on digitalise successivement chaque image de commande (Ia) en une image binaire (Ib) de commande sur laquelle la pastille (18) apparait avec un niveau binaire spécifique notamment (zéro) dinstinct de celui du fond (20) du cliché (1) de référence,

on effectue successivement un traitement électronique automatique de chaque image binaire (Ib) de commande et on détermine automatiquement les coordonnées des centres rééls (C'18) de chaque pastille (18) à percer,

on génère une nouvelle séquence programme corrigée (41''), à partir des coordonnées exactes des centres (C'18).

on mémorise cette nouvelle séquence de programme de perçage corrigée sur un support programme secondaire (21''),

on peut alors utiliser la nouvelle séquence de programme (41'') sur une perceuse à commande numérique.

5. Dispositif (49) de correction automatique, selon le procédé d'une des revendications 1 à 4, de programme d'usinage (21) d'une machine à commande numérique.

Le dispositif (49) comportant:

un dispositif optique (55),

un systéme mécanique (59) de de la déplacement bidirectionnel assurant le mouvement selon deux directions (X X') et (Y Y'), d'une platine (61), vis-à-vis de l'axe (Z Z') de dispositif optique (55),

une platine (61) déplacée par le système mécanique (59), sur laquelle sont fixés les plans de référence (1),

un système d'éclairage (63) de la zone platine (Zo) inspectée par le dispositif optique (55),

un calculateur (71) à microprocesseur, relié au système mécanique (59) par l'intermédiaire d'organes de puissance (79) pour assurer le séquencement automatique des mouvements,

un système d'imagerie électronique (77), relié au dispositif optique (55),

recevant des images analogiques (Ia) de commande du plan de référence (1),

assurant la digitalisation de ces images de commande (Ia) sous forme d'images binaires (Ib) englobant successivement les formes d'usinage (18),

analysant les images binaires de commande (Ib),

et détectant sur lesdites images binaires (Ib) de commande, les coordonnées exactes des points centraux (C'18) des figures d'usinage (18).

Ledit dispositif (49) étant caractérisé:

en ce que d'une part, il comporte en outre, en combinaison:

un système (82) de lecture des supports programmes primaires (21) de séquence initiale (41) de programme de machines à commande numérique,

en un système d'écriture (83) sur des supports programmes secondaires (21''), des séquences programmes corrigées (41'') après lecture de la séquence initiale (41) et correction avec le système d'imagerie (77),

et d'autre part, le calculateur de commande (71) assure:

la lecture des supports programmes primaires (21) de séquence initiale (41) de programme,

l'identification à partir de cette séquence programme initiale (41) des figures théoriques (18),

la détermination des coordonnées de points centraux théoriques (C18) des figures théoriques (18),

la commande automatique de déplacement du système mécanique (59) pour amener successivement chaque point central théorique (C18) à la quasi verticale de l'axe (Z Z') du dispositif optique (55),

le calcul d'éléments géométriques d'écart (C18, C'18) entre la figure théorique (18) et la figure réelle, et notamment l'écart entre le point central théorique (C18) et le point central réel (C'18),

la génération sur le système d'écriture (83) d'une séquence programme corrigée (41''), enregistrée sur un support programme secondaire (21'').

**Patentansprüche**

1. Automatisches Verfahren zur Korrektur eines Bearbeitungsprogramms (41) für Maschinen mit numerischer Steuerung in Verbindung mit einem Referenzmaßplan (1), auf dem die Muster (15, 16, 17, 18) des Bearbeitungsverlaufs vom Hintergrund durch einen spezifischen Parameter wie deren Graupegel unterscheidbar sind, wobei das Verfahren darin besteht,

ausgehend vom Referenzplan (1) zuerst eine anfängliche Programmsequenz (41) der numerisch gesteuerten Maschine zu schaffen, dies insbesondondere auf einem klassischen Programmiersystem (25),

und die Gesamtheit der genannten Programmsequenz (41) auf einem primären Programmträger (21) zu speichern, wobei das genannte Verfahren durch die Kombination gekennzeichnet ist, daß man vor dem Eingeben der genannten anfänglichen Programmsequenz (41) in das Innere der numerisch gesteuerten Maschine:

den primären Programmträger (21) liest und seine anfängliche Programmsequenz (41) entschlüsselt,

daß man ausgehend von dieser anfänglichen Programmsequenz (41) einer Serie von theoretischen Mustern (15, 16, 17, 18) isoliert, bevor sie durch die numerisch gesteuerte Maschine verarbeitet werden,

daß man nacheinander die theoretischen Koordinaten eines zentralen theoretischen Punktes (C15, C16, C17, C18) jedes theoretischen Musters (15, 16, 17, 18) bestimmt,

daß man den Referenzplan (1) gegenüber einem optischen System (55) auf eine Weise bewegt, daß der zentrale theoretische Punkt (C15, C16, C17, C18) jedes theoretischen Musters (15, 16, 17, 18) nacheinander im wesentlichen der Vertikalen der Achse (Z Z') des optischen Systems (55) zugeführt wird,

daß man nacheinander ein Steuerbild (1a) erfaßt, das jeden zentralen theoretischen Punkt (C18) umgibt und das entsprechende Muster (18) umfaßt,

daß man das genannte Steuerbild (1a) sukzessive in ein binäres Steuerbild (1b) digitalisiert, auf dem das genannte theoretische Muster (18) mit einem spezifischen binären Pegel erscheint,

daß man eine automatische elektronische Verarbeitung des binären Steuerbildes (1b) durchführt und automatisch die exakten Koordinaten der Bearbeitungsmuster auf dem Referenzplan bestimmt,

daß man eine neu korrigierte Programmsequenz (41'') auf der Basis der zuvor bestimmten exakten Koordinaten erzeugt,

daß man die neue korrigierte Programmsequenz (41'') auf einem sekundären Programmträger (21'') abspeichert,

daß man dann die neue korrigierte Programmsequenz (41'') verwenden kann, em auf einer numerisch gesteuerten Maschine Stücke in übereinstimmung mit dem Referenzplan (1) zu bearbeiten.

2. Automatisches Verfahren gemäß dem vorhergehenden Anspruch 1 zur Korrektur eines Bearbeitungs-programmes (41) für numerisch gesteuerte Maschinen, wobei dieses Verfahren dadurch gekennzeichnet ist, daß man in der korrigierten Programmsequenz (41'') die Struktur der anfänglichen Programmsequenz (41) aufrechterhält; daß man einfach die bezüglich der theoretischen Muster falschen numerischen Werte durch exakte numerische Werte ersetzt, mit Präzision entsprechend der Geometrie und der Position der theoretischen Muster, wie sie gemäß dem Verfahren des Patentanspruchs 1 bestimmt worden sind.

3. Automatisches Verfahren gemäß einem der vorhergehenden Patentansprüche 1 und 2 zur Korrektur eines Bearbeitungsprogrammes für numerisch gesteuerte Maschinen, bei welchen:

man sich auf dem Referenzplan (1) einen Ursprungspunkt (C16) der anfänglichen Programmsequenz (41)

sowie eine Referenzhorizontale festlegt, wodei das Verfahren durch die Kombination gekennzeichnet ist daß:

man sich einen primären Ursprungspunkt (C16) der anfänglichen Programmsequenz festlegt, welcher mit einem zentralen charakeristischen Punkt eines Musters (16) des Referenzplanes (1) zusammenfällt,

daß man sich gleichfalls zur Definition der Horizontalen zwei sekundäre und tertiäre Punkte (C19) zur Ausrichtung der Achsen festlegt, von denen einer (C16) gegebenenfalls durch den Ursprungspunkt gebildet ist, die mit zwei zentralen charakteristischen komplementären Punkten zweier Figuren (19) des Referenzplanes zusammenfallen,

daß man im Laufe der Korrekturphase der Programmsequenz die Achse (Z Z') des optischen Systems (55) nacheinander im wesentlichen der primären (C16), sekundären und tertiären (C19) Referenzpunkte zuführt,

daß man automatisch eine Referenzmarkierung (R) des Planes (1) bestimmt, die gegenüber der optischen Vorrichtung (55) beweglich ist,

daß man mit Hilfe dieser theoretischen Koordinaten jeden zentralen theoretischen Punkt (C15) nacheinander der Quasi-Vertikalen der Achse (Z Z') der optischen Vorrichtung (55) zuführt, um zur Steuerung der anfänglichen Programmsequenz (41) und zu ihrer automatischen Korrektur in der Form der korrigierten Programmsequenz (41'') zu schreiten.

4. Automatisches Verfahren gemäß einem der vorhergehenden Ansprüche 1 bis 3 zur Korrektur eines Programmes zur Durchbohrung von gedruckten Schaltkreisen für numerisch gesteuerte Bohrmaschinen, wobei das genannte Programm ausgehend von einer Referenzabbildung (1) realisiert ist, die durch einen transparenten Trägerplan gebildet ist, auf dem angeordnet sind:

schwarze Scheibchenflächen (15, 16, 17, 18) mit zentraler Symmetrie, von denen das Zentrum (C15, C16, C17, C18) die Positionen der Durchbohrung verkörpert,

und eventuell Verbindungen (5, 6, 7, 8, 9, 10, 11). Das genannte Verfahren ist gekennzeichnet durch die Kombination, daß man

ausgehend von der Referenzabbildung (1) insbesondere mit Hilfe eines klassischen Koordinatographen (25) eine anfängliche Programmsequenz für numerisch gesteuerte Bohrmaschinen schafft,

daß man diese anfängliche Programmsequenz (41) auf einem primären Programmträger (21) speichert,

daß man auf einem unabhängigen System (49) den primären Programmträger (41) liest und die anfängliche Bohrungs-Programmsequenz (21) entschlüsselt,

daß man die Koordinaten der theoretischen Bohrungszentren (C18) isoliert, die theoretisch mit dem Zentrum der Scheibchenflächen (18) zusammenfallen,

daß man die Referenzabbildung (1) auf eine Platine (61) eines Systems gibt, das gegenüber der Achse (Z Z') einer optischen Vorrichtung (55) beweglich ist, und man die Abbildung (1) bewegt,

daß man nacheinander und automatisch die theoretischen Bohrungszentren (C18) der Vertikalen der Achse (Z Z') der optischen Vorrichtung (55) zuführt,

daß man nacheinander mit Hilfe des optischen Systems (55) ein Steuerbild (1a) erfaßt, das jedes theoretische Zentrum (C18) und die ensprechende Scheibchenfläche (18) umgibt,

daß man nacheinander jedes Steuerbild (1a) in ein digitales Steuerbild (1b) digitalisiert, auf dem die Scheibchenfläche (18) mit einem spezifischen binären Pegel (insbesondere null) aufscheint, der sich von jenem des Hintergrundes (20) der Referenzabbildung abhebt,

daß man nacheinander eine automatische elektronische Verarbeitung jedes binären Steuerbildes (1b) durchführt und man automatisch die Koordinaten der wirklichen Zentren (C'18) der zu durchbohrenden Scheibchenflächen (18) bestimmt,

daß man eine neue korrigierte Programmsequenz (41'') ausgehend von den exakten Koordinaten der Zentren (C'18) erzeugt,

daß man diese neue korrigierte Bohrungs-Programmsequenz auf einem sekundären Programmträger (21'') speichert,

daß man dann die neue Programmsequenz (41'') auf einer numerisch gesteuerten Bohrmaschine verwenden kann.

5. Einrichtung (49) zur automatischen Korrektur eines Bearbeitungsprogrammes (21) einer numerisch gesteuerten Maschine, gemäß dem Verfahren eines der Ansprüche 1 bis 4.
Die Einrichtung (49) umfaßt:

eine optische Vorrichtung (55),

ein in zwei Richtungen bewegliches mechanisches Verschiebesystem (59), das die Bewegung gemäß den beiden Richtungen (X X') und (Y Y') einer Platine (61) gegenüber der optischen Achse (Z Z') der optischen Vorrichtung (55) sicherstellt,

eine Platine (61), die durch das mechanische System (59) bewegt wird und auf der die Referenzpläne (1) fixiert sind,

ein Beleuchtungssystem (63) der Zone der Platine (Zo), die durch die optische Vorrichtung (55) betrachtet wird,

einen Rechner (71) mit Mikroprozessor, der an das mechanische System (59) mittels Leistungsorganen (79) verbunden ist, um die automatische Abfolge der Bewegungen sicherzustellen,

ein an die optische Vorrichtung (55) angeschlossenes elektronisches Bildverarbeitungssystem (77),

das analoge Steuerbilder (1a) des Referenzplanes (1) empfängt,

das die Digitalisierung dieser Steuerbilder (1a) in Form von binären Bildern (1b) sicherstellt, die nacheinander die Bearbeitungsformen (18) umgeben,

das die binären Steuerbilder (1b) analysiert und das auf den genannten binären Steuerbildern die exakten Koordinaten der Mittelpunkte (C'18) der Bearbeitungsmuster (18) erfaßt.
Die genannte Einrichtung (49) ist dadurch gekennzeichnet,
daß sie einerseits weiters in Kombination umfaßt:

ein System (82) zum Lesen der primären Programmträger (21) mit der anfänglichen Programmsequenz (41) für numerisch gesteuerte Maschinen,

und ein System (83) zum Schreiben korrigierter Programmsequenzen (41'') auf sekundäre Programmträger (21'') nach dem Lesen der anfänglichen Programmsequenz (41) und der Korrektur mit dem Bildverarbeitungssystem (77),

und daß andererseits der Steuerungsrechner (71) sicherstellt:

das Lesen der primären Programmträger (21) der anfänglichen Programmsequenz (41),

die Identifizierung theoretischer Muster (18), ausgehend von dieser anfänglichen Programmsequenz (41),

die Bestimmung der Koordinaten der zentralen theoretischen Punkte (C18) der theoretischen Muster (18),

die automatische Steuerung der Verschiebung des mechanischen Systems (59), um nacheinander jeden zentralen theoretischen Punkt (C18) der Quasi-Vertikalen der Achse (Z Z') der optischen Vorrichtung (55) zuzuführen,

die Berechnung geometrischer Abstandselemente (C18, C'18) zwischen dem the theoretischen Muster (18) und dem reellen Muster und insbesondere des Abstandes zwischen dem zentralen theoretischen Punkt (C18) und dem zentralen reellen Punkt (C'18),

die Erzeugung einer korrigierten Programmsequenz (41'') auf dem Schreibsystem (83), welche Programmsequenz auf einem sekundären Programmträger (21'') gespeichert ist.

**Claims**

1. Automatic process for correcting a machining programme (41) for numeric control machines in relation to a metrological reference plane (1) on which the figures (15, 16, 17, 18) of the machining pattern are discernible from the background by a specific parameter such as their grey level; the process consists:

first in making use of the reference plane (1) in order to establish an initial programme sequence (41) of the numeric control machine, in particular on a conventional programming system (25),

and in storing the entire initial programme sequence (41) aforesaid on a primary programme carrying medium (21),

said process being characterized in combination in that, before introducing said initial programme sequence (41) into the numeric control machine:

the primary programme medium (21) is read and its initial programme sequence (41) is deciphered,

starting from this initial programme sequence (41), one isolates a series of theoretical figures (15, 16, 17, 18) to be machined by the numeric control machine,

the theoretical coordinates of a theoretical central point (C15, C16, C17, C18) of each theoretical figure (15, 16, 17, 18) are determined successively,

the reference plane (1) is displayed opposite to an optical system (55) so as to bring the theoretical central point (C15, C16, C17, C18) of each theoretical figure (15, 16, 17, 18) successively into substantially vertical alignment with the axis (Z Z') of the optical system (55),

a control image (Ia) surrounding each theoretical central point (C18) and comprising the corresponding figure (18) is acquired successively,

said control image is successively digitized in a binary control image (Ib) on which said theoretical figure (18) appears with a specific binary level,

automatic electronic processing of the binary control image (Ib) is carried out and the exact coordinates, on the reference plane (1), of the figures to be machined are determined automatically,

one generates a new corrected programme sequence (41'') on the basis of the predetermined exact coordinates,

the new corrected programme sequence (41'') is stored on a secondary programme carrying medium (21''),

the new corrected programme sequence (41'') can then be employed for machining, on a numeric control machine, parts which correspond to the reference plane (1).

2. Automatic process in accordance with the preceding claim 1 for correcting a machining programme (41) for numeric control machines, this process being characterized in that the structure of the initial programme sequence (41) is retained in the corrected programme sequence (41''); the erroneous numerical values relative to the theoretical figures are simply replaced by correct numerical values which accurately correspond to the geometry and to the position of the theoretical figures as determined in accordance with the process in claim 1.

3. Automatic process in accordance with either of the preceding claims 1 and 2 for correcting a machining programme for numeric control machines, in which:

there are established on the reference plane (1) an origin point (C16) of the initial programme sequence (41),

as well as a reference horizontal,
said process being characterized in combination in that:

a primary origin point (C16) of the initial programme sequence is established and coincides with a central point which is characteristic of a figure (16) of the reference plane (1),

there are also established, in order to define the horizontal, two secondary and tertiary points (C19) of alignment of axes, one of which (C16) may be constituted by the origin point which coincides with two complementary characteristic central points of two figures (19) of the reference plane,

and during the stage of correction of the programme sequence, the axis (Z Z') of the optical system (55) is brought successively into substantially vertical alignment with the reference primary point (C16), secondary and tertiary points (C19),

a reference line (R) of the plane (1) which is movable with respect to the optical device (55) is determined automatically,

one defines the theoretical coordinates of said theoretical central points (45) of the theoretical figures (15) in the reference line (R) of the plane (1),

by means of these theoretical coordinates, each theoretical central point (C15) is brought successively into practically vertical alignment with the axis (Z Z') of the optical device (55) in order to check the initial programme sequence (41) and to carry out its automatic correction on the form of the corrected programme sequence (41'').

4. Automatic process in accordance with one of the preceding claims 1 to 3 for the correction of a printed circuit drilling programme for numeric control drilling machines, said programme being carried out on the basis of a reference negative (1) constituted by a transparent flat carrying medium (3) on which are placed:

black pads (15, 16, 17, 18) having central symmetry, the centre of which (C15, C16, C17, C18) materializes the drilling positions,

and if necessary connectors (5, 6, 7, 8, 9, 10, 11), said process being characterized in that in combination:

an initial programme sequence of numeric control drilling machines is established on the basis of the reference negative (1), in particular by means of a conventional coordinatograph (25),

the initial sequence (41), of the programme is stored on a primary programme carrying medium (21),

the primary programme carrying medium (41) is read on an independent system (49) and the initial drilling programme sequence (21) is deciphered,

the coordinates of the theoretical drilling centres (C18) which coincide theoretically with the centres of the pads (18) are isolated,

the reference negative (1) is placed on the support plate (61) of a system which is movable with respect to the axis (Z Z') of an optical device (55) and the negative (1) is displaced,

the theoretical drilling centres (C18) are brought successively and automatically into vertical alignment with the axis (Z Z') of the optical device (55),

there is successively acquired by means of the optical device (55) a control image (Ia) which surrounds each theoretical centre (C18) and the corresponding pad (18),

each control image (Ia) is successively digitized in a control binary image (Ib) on which the pad (18) appears with a specific binary level (in particular zero) which is distinct from that of the background (20) of the reference negative (1),

automatic electronic processing of each control binary image (Ib) is carried out successively and the coordinates of the real centres (C'18) of each pad (18) to be drilled are determined automatically,

A new corrected programme sequence (41'') is generated from the exact coordinates of the centres (C'18),

this new corrected drilling programme sequence is stored on a secondary programme carrying medium (21''),

the new programme sequence (41'') can then be employed on a numeric control drilling machine.

5. Device (49) in accordance with the process of one of claims 1 to 4 for automatic correction of the machining programme (21) of a numeric control machine.

The device (49) comprises:

an optical device (55),

a machanical bidirectional displacement system (59) for carrying out the movement in two directions (X X') and (Y Y') of a support plate (61) with respect to the axis (Z Z') of the optical device (55),

a support plate (61) displaced by the mechanical system (59), on which the reference planes (1) are fixed,

a system (63) for illuminating the plate zone (Zo) which is inspected by the optical device (55),

a microprocessor computer (71) connected to the mechanical system (59) by means of power elements (79) for ensuring automatic sequencing of the movements,

an electronic imaging system (77), connected to the optical device (55),

for receiving control analogue images (Ia) of the reference plane (1),

for carrying out digitization of said control images (Ia) in the form of binary images (Ib) which successively comprise the machining forms (18),

for scanning the control binary images (Ib),

and for detecting on said control binary images (Ib) the exact coordinates of the central points (C'18) of the machining figures (18).

Said device (49) being characterised:

in that on the one hand it further comprises in combination:

a system (82) for reading primary programme media (21) of an initial programme sequence (41) of numeric control machines,

and a system (83) for writing corrected programme sequences (41'') on secondary programme media (21'') after reading of the initial sequence (41) and correction with the imaging system (77),

and on the other hand the control computer (71) carries out:

reading of the primary programme media (21) of the initial programme sequence (41),

identification of the theoretical figures (18) from said initial programme sequence (41),

determination of the coordinates of theoretical central points (C18) of the theoretical figures (18),

automatic control of displacement of the mechanical system (59) for successively bringing each theoretical central point (C18) into practically vertical alignment with the axis (Z Z') of the optical device (55),

computation of geometrical elements of difference (C18, C'18) between the theoretical figure (18) and the real figure, and in particular the difference between the theoretical central point (C18) and the real central point (C'18),

generation on the writing system (83) of a corrected programme sequence (41'') recorded on a secondary programme medium (21'').

Fig.1

Fig.2

EP 0 213 975 B1

Fig. 3